# FASCICULE DE BREVET EUROPEEN

(11) **EP 4 362 652 B1**
(45) Date de publication et mention de la délivrance du brevet: **03.09.2025**
(21) Numéro de dépôt: 23205389.2
(22) Date de dépôt: 24.10.2023
(51) Int. Cl.: H10N 70/20, H10B 63/00

(54) **DISPOSITIF MÉMOIRE RÉSISTIVE ET SON PROCÉDÉ DE RÉALISATION**
RESISTIVE SPEICHERVORRICHTUNG UND DEREN HERSTELLUNGSVERFAHREN
RESISTIVE MEMORY DEVICE AND FABRICATION METHOD THEREOF

(30) Priorité: 25.10.2022 FR 2211046
(43) Date de publication de la demande: 01.05.2024
(73) Titulaire: Commissariat à l'Energie Atomique et aux Energies Alternatives, 75015 Paris (FR)
(72) Inventeur: CHARPIN-NICOLLE, Christelle, 38054 GRENOBLE Cedex 09 (FR); BLONKOWSKI, Serge, 38054 GRENOBLE Cedex 09 (FR); GASSILLOUD, Rémy, 38054 GRENOBLE Cedex 09 (FR); MAGIS, Thomas, 38054 GRENOBLE Cedex 09 (FR)
(74) Mandataire: Hautier IP

(56) Documents cités:
- EP-A1- 4 142 460
- US-A1- 2011 108 399
- US-A1- 2011 204 310
- US-A1- 2014 353 570
- US-B1- 10 050 194

## Description

### DOMAINE TECHNIQUE

La présente invention concerne, en général, un dispositif mémoire résistive, et plus particulièrement, un dispositif mémoire résistive non volatile et son procédé de réalisation.

### ETAT DE LA TECHNIQUE

Les mémoires résistives de type RRAM ou ReRAM (acronyme anglais de « Resistive Random Access Memories » signifiant « mémoires résistives à accès aléatoire ») sont actuellement développées pour les applications non-volatiles, dans le but de remplacer les mémoires de type Flash. Elles présentent notamment pour avantage de pouvoir être intégrées dans des lignes d'interconnexion au niveau BEOL (acronyme BEOL en anglais pour « Back-End Of Line ») de la technologie CMOS (acronyme en anglais pour « Complementary Metal-Oxide-Semiconductor » signifiant technologie à base de transistors « Métal-Oxyde-Semiconducteur complémentaires »). Les mémoires résistives RRAM sont des dispositifs comprenant notamment un élément de résistance variable, appelé élément mémoire, disposé entre deux électrodes. La résistance électrique de cet élément mémoire peut être modifiée par des opérations d'écriture et d'effacement. Ces opérations d'écriture et d'effacement permettent de faire passer le dispositif mémoire résistive RRAM d'un état basse résistance LRS (acronyme en anglais pour « Low Resistive State ») à un état haute résistance HRS (acronyme en anglais pour « High Resistive State »), et inversement.

En fonction de la nature de l'élément mémoire, différentes catégories ou sous-catégories de RRAM peuvent être définies. Les mémoires résistives dont l'élément mémoire est à base d'un matériau à changement de phase, typiquement à base de chalcogénures ou de pérovskites, sont généralement appelées PCRAM (acronyme anglais de « Phase Change Random Access Memories »). Dans ce type de mémoire, le passage LRS/HRS se fait par un changement de phase activé thermiquement. Les mémoires résistives dont l'élément mémoire est à base d'un oxyde métallique sont généralement appelées OxRAM (acronyme anglais de « Oxide Resistive Random Access Memories »). Dans ce type de mémoire, le passage LRS/HRS se fait par création d'un filament conducteur au travers de l'oxyde, par application d'une tension électrique suffisamment élevée. Les mémoires résistives dont l'élément mémoire est à base d'un électrolyte sont généralement appelées CBRAM (acronyme anglais de « Conductive-Bridging Random Access Memories »). Dans ce type de mémoire, le passage LRS/HRS se fait par création d'un nanofil métallique issu d'une réduction d'ions métalliques dans l'électrolyte.

Chacun de ces types de mémoire présente des problématiques spécifiques (gestion thermique, variabilité des performances cycle-à-cycle, réactivité...) qui constituent aujourd'hui un frein à l'industrialisation.

Récemment, d'autres types de RRAM basées sur l'état de conduction réversible d'un nano-filament métallique ont été développées.

Le document « Memristive switching of single-component metallic nanowires, S.L. Johnson et al. Nanotechnology 21 (2010) 125204 » divulgue une architecture comprenant un élément mémoire métallique intercalé entre deux électrodes, dans laquelle l'élément mémoire métallique présente une constriction géométrique de dimension nanométrique. Un tel « nanofil » métallique peut s'ouvrir (nanogap) et se fermer, au moins partiellement, par électromigration et par Effet Joule. Ces deux effets augmentent la probabilité qu'un atome métallique quitte ou remplisse la constriction lorsque la différence de potentiel entre les deux électrodes augmente. A l'état « On », la conduction dans le nanofil est limitée par la surface de la section de la constriction. A l'état « Off », la conduction est limitée par effet tunnel au travers du nanogap. Des conductances à l'état On de 60 mS et à l'état Off de 30 mS ont été obtenues pour des nanofils en or de section 100 nm par 20 nm formés par lithographie électronique. Des dispositifs similaires sont connus des demandes de brevet US 2011/204310 A1 et US 2014/353570 A1, par exemple.

Ces dispositifs réalisés en laboratoire et cette méthode de formation sont difficilement industrialisables. L'efficacité de ce dispositif mémoire reste limitée.

Un objectif de la présente invention est de pallier au moins en partie les inconvénients mentionnés ci-dessus.

Un objectif de la présente invention est de proposer un dispositif mémoire résistive comprenant un élément mémoire sous forme de nano-filament métallique, qui soit industrialisable et qui présente une efficacité améliorée.

Un autre objectif de la présente invention est de proposer un procédé de fabrication d'un tel dispositif mémoire résistive.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un dispositif mémoire résistive comprenant au moins une première électrode à base d'un premier métal et une deuxième électrode à base d'un deuxième métal, et un élément mémoire sous forme de filament métallique à base d'un troisième métal et intercalé entre lesdites première et deuxième électrodes.

L'élément mémoire présente une section transverse de filament, prise dans un plan transverse passant entre les première et deuxième électrodes, et les première et deuxième électrodes présentent chacune une section transverse d'électrode, prise respectivement dans un plan passant par ladite électrode et parallèle au plan transverse.

La section transverse de filament est strictement inférieure aux sections transverses d'électrodes, et, la section transverse de filament présente au moins une dimension inférieure ou égale à 20 nm.

Avantageusement, le troisième métal présente une composition chimique différente de celles des premier et deuxième métaux, et cette composition chimique lui confère une vitesse de gravure supérieure à celles des premier et deuxième métaux. La composition chimique du troisième métal est de préférence telle que la sélectivité à la gravure soit supérieure ou égale à 2:1, et de préférence supérieure ou égale à 3:1, vis-à-vis des premier et deuxième métaux.

Ainsi, l'élément mémoire forme une constriction géométrique métallique appelée filament par la suite, entre les première et deuxième électrodes. Les propriétés de sélectivité à la gravure du troisième métal permettent typiquement de former l'élément mémoire par simple gravure, contrairement aux solutions connues dans lesquelles l'élément mémoire est formé par lithographie électronique. Cela rend un tel dispositif compatible avec une production industrielle de masse, contrairement aux solutions connues. En effet, la lithographie électronique utilisée par les solutions connues induit un coût et un temps de procédé très élevés, car les motifs de filament sont généralement définis et formés un par un. Au contraire, de nombreux filaments peuvent être formés simultanément grâce à la configuration du dispositif mémoire résistive et aux propriétés du filament selon la présente invention. Le dispositif selon la présente invention présente ainsi une industriabilité très supérieure aux dispositifs connus.

Selon un aspect, l'invention a pour objet un système comprenant le dispositif et un transistor formé dans un substrat portant ledit dispositif, le transistor étant relié au dispositif par au moins un niveau d'interconnexions. Le transistor est typiquement configuré pour commander un passage de courant électrique dans l'élément mémoire, entre les première et deuxième électrodes. Les première et deuxième électrodes et l'élément mémoire peuvent notamment former un empilement vertical appelé point mémoire. Ce point mémoire est ainsi typiquement interconnecté au transistor via un ou plusieurs niveaux de métal et/ou d'interconnexions. Un tel système comprenant un transistor directement intégré avec le point mémoire est parfaitement industrialisable par les procédés de la technologie CMOS. Un tel système permet en outre d'associer le transistor de commande au plus près du point mémoire. Cela permet de limiter le temps de connexion et la tension de commutation du filament. Le délai pour la commande du courant passant dans le filament est réduit. Dans les systèmes et dispositifs connus, l'usage d'un équipement de commande externe induit un délai pour la limitation du courant passant dans le filament. Durant ce délai la section du filament peut être endommagée par un excès de courant (« overshoot ») de telle sorte que le point mémoire ne soit plus fonctionnel. L'intégration d'un transistor et d'un filament métallique comprenant une constriction nanométrique, au sein d'un même système selon un exemple de réalisation de la présente invention permet de réduire considérablement ce délai. Le fonctionnement du dispositif mémoire est ainsi plus sûr et plus efficace.

Selon un autre aspect de l'invention, on prévoit un procédé de réalisation d'un dispositif mémoire résistive, comprenant :
- Un dépôt d'une première couche à base du premier métal, sur un substrat,
- Un dépôt d'une troisième couche à base du troisième métal, sur la première couche,
- Un dépôt d'une deuxième couche à base du deuxième métal, sur la troisième couche, de sorte à former un empilement des première, troisième et deuxième couches, selon une direction verticale z,
- Une gravure de l'empilement, selon la direction verticale z, de façon à former les première et deuxième électrodes,
- Une surgravure configurée pour consommer latéralement, selon une direction horizontale d'un plan xy horizontal perpendiculaire à la direction verticale z, le troisième métal sélectivement aux premier et deuxième métaux, de façon à former l'élément mémoire sous forme de filament métallique intercalé entre lesdites première et deuxième électrodes.

Le procédé permet ainsi de former facilement, à coût réduit, un dispositif mémoire résistive comprenant un élément mémoire sous forme de filament métallique.

L'étape de surgravure permet de réduire uniquement au moins une dimension latérale de l'élément mémoire, sans réduire les dimensions latérales des première et deuxième électrodes.

La sélectivité S à la gravure correspond ici à la différence de vitesse de gravure entre le troisième métal et les premier et deuxième métaux d'électrodes, lors de la surgravure. Une sélectivité S ≥ 2:1 ou S ≥ 3:1 permet *de facto* d'obtenir un retrait latéral plus important au niveau du filament lors de la surgravure. Les paramètres de l'étape de surgravure sont ici choisis, en accord avec la sélectivité S, de façon à permettre un retrait latéral de sorte que la section transverse de filament, prise dans un plan xy, présente au moins une dimension inférieure ou égale à 20 nm après la surgravure.

Cela permet d'obtenir un filament métallique fonctionnel pour les phases de fonctionnement ultérieur du dispositif mémoire résistive. En particulier, la commutation du dispositif mémoire résistive par effet Joule et/ou par électromigration est permise.

Selon une possibilité, l'étape de surgravure peut être avantageusement réalisée en prolongement et dans la continuité de la gravure de l'empilement. Cela permet de limiter le nombre d'étapes total du procédé. Il n'est par exemple pas nécessaire de prévoir des étapes de lithographie supplémentaires.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1 à 5 illustrent schématiquement des étapes de réalisation d'un dispositif mémoire résistive, selon un mode de réalisation de la présente invention.
La figure 6 est un agrandissement du dispositif en cours de fabrication illustrée à la figure 5.
Les figures 7 et 8 illustrent schématiquement des étapes de réalisation d'un dispositif mémoire résistive, selon un mode de réalisation de la présente invention.
La figure 9 illustre un dispositif mémoire résistive selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas nécessairement représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, les première et deuxième électrodes et l'élément mémoire sont empilés selon une direction dite verticale z, sur un substrat s'étendant selon un plan xy dit horizontal et perpendiculaire à la direction verticale z. Cela permet d'augmenter la compacité du dispositif. L'intégration d'un tel dispositif au sein d'un circuit électronique est améliorée.

Selon un exemple, l'élément mémoire forme un retrait latéral vis-à-vis des première et deuxième électrodes dans toutes les directions du plan horizontal xy, de sorte que ledit élément mémoire soit sensiblement centré vis-à-vis des première et deuxième électrodes, en projection dans le plan horizontal xy. Les dimensions latérales du filament métalliques sont ainsi sensiblement constantes. Le filament métallique s'apparente ainsi à un cylindre de diamètre inférieur ou égal à 20 nm dans le plan xy. La section transverse du filament est minimisée. Cela diminue le courant et/ou la tension nécessaires à la commutation du dispositif. Selon un exemple, le filament présente, dans le plan transverse, une section en forme de disque, de carré ou de rectangle.

Selon un exemple, les premier et deuxième métaux sont à base d'un métal de transition ou d'un nitrure dudit métal de transition, et le troisième métal est à base d'un alliage d'aluminium et dudit métal de transition, ou d'un autre métal de transition.

Selon un exemple, la section transverse de filament présente une dimension L2 inférieure ou égale à 15 nm dans le plan transverse, et les sections transverses d'électrodes présentent chacune une dimension L1 supérieure ou égale à 100 nm, dans un plan parallèle audit plan transverse. Une telle constriction géométrique permet d'augmenter la densité de courant dans le filament. La commutation est facilitée.

Selon un exemple, les premier et deuxième métaux sont à base de Ti ou de TiN, et le troisième métal est à base de TixAly, avec x, y > 0.

Selon un exemple, le dispositif est associé à un transistor formé dans un substrat portant les première et deuxième électrodes et l'élément mémoire, le transistor étant configuré pour commander un passage de courant électrique dans l'élément mémoire, entre les première et deuxième électrodes. L'élément mémoire et le transistor de commande sont ainsi intégrés dans un même empilement. L'élément mémoire est typiquement intégré dans un niveau BEOL d'un circuit électronique et est connecté à un transistor d'un niveau FEOL dudit circuit, via un ou plusieurs niveaux d'interconnexions et de pistes métalliques (niveaux « métal »). La longueur de connexion est ainsi minimisée. Le délai de limitation, égal au produit de la résistance de la connexion par la capacité de la connexion reliant le filament, est minimisé. La tension de commutation est ainsi réduite.

Selon un exemple, la gravure de l'empilement et/ou la surgravure sont réalisés par plasma à base d'une chimie chlorée. Selon un autre exemple, le plasma peut être à base d'une chimie fluorée, ou bromée, ou iodée.

Selon un exemple, la surgravure correspond à une prolongation de l'étape de gravure, par application d'un temps de gravure supérieur à celui permettant de graver l'empilement selon la direction verticale z. La surgravure est ainsi réalisée en continuité de la gravure de l'empilement, en prolongeant la durée de ladite gravure. Cela permet de réduire la durée totale du procédé de formation du filament, en évitant par exemple une purge pour changer la chimie du plasma de gravure. Selon un exemple, la gravure et la surgravure se font par plasma à base d'une chimie chlorée.

Selon un exemple, la gravure est configurée pour être anisotrope selon la direction verticale z, et la surgravure est configurée pour être isotrope, de sorte que l'élément mémoire forme un retrait latéral vis-à-vis des première et deuxième électrodes dans toutes les directions du plan horizontal xy, ledit élément mémoire étant ainsi sensiblement centré vis-à-vis des première et deuxième électrodes, en projection dans le plan horizontal xy. Selon un exemple, la tension de bias appliquée lors de la gravure est une tension V1 non nulle et la tension de bias appliquée lors de la surgravure est une tension de bias V2 inférieure strictement à V1, par exemple, V2 = 0V.

Selon un exemple, les premier et deuxième métaux sont choisis à base de Hf, Zr, W, Ti, Ta, TaN ou TiN, et le troisième métal est choisi à base de TixAly, ZrxAly, HfxAly, TaxAly, WxAly avec x, y > 0. En particulier, dans un plasma de gravure en chimie chlorée, l'aluminium se grave entre deux et trois fois plus vite que le métal de transition qui lui est associé. On utilise donc avantageusement cette sélectivité de gravure pour former le filament métallique, par exemple à base d'un alliage d'aluminium de titane, entre les électrodes, par exemple à base de titane. Selon une possibilité, on choisira y ≥ 0,3. Plus la concentration en aluminium y est élevée, plus la sélectivité à la gravure augmente. Cela permet par exemple de limiter le temps de surgravure. Cela permet d'obtenir des facteurs de forme importants entre le filament et les électrodes.

Selon un exemple, le procédé comprend en outre une intégration de l'empilement sur un substrat comprenant un transistor configuré pour commander un passage de courant électrique dans l'élément mémoire, entre les première et deuxième électrodes, ladite intégration comprenant au moins la formation de connexions électriques entre ledit transistor et l'une au moins parmi les première et deuxième électrodes. La formation de connexions électriques correspond typiquement à des étapes BEOL des procédés utilisés dans le domaine de la microélectronique. Elles succèdent généralement aux étapes FEOL permettant de fabriquer les composants élémentaires tels que les transistors. Ce procédé de fabrication d'un dispositif mémoire résistive s'inscrit donc parfaitement dans un flux de procédés d'intégration utilisés dans le domaine de la microélectronique.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques et avantages du dispositif selon l'invention peuvent s'appliquer, *mutatis mutandis,* aux caractéristiques et avantages du procédé selon l'invention, et inversément.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, une couche à base de titane s'entend par exemple d'une couche Ti, ou par exemple TiN.

On entend par une structure « métallique » ou « à base de métal », une structure présentant des propriétés d'un métal. Ainsi, une structure métallique, par exemple le filament, comprend nécessairement au moins une partie purement métallique. Le filament peut par exemple présenter un coeur métallique entouré par une fine couche d'oxyde métallique. Seul le coeur est considéré comme étant purement métallique. L'oxyde métallique ne présente pas les propriétés de conduction électrique d'un métal. Le filament ne peut pas être entièrement à base d'oxyde métallique. Les éléments mémoire des OxRAM à base d'oxyde métallique ne peuvent pas être assimilés à un filament métallique tel que décrit et illustré dans le cadre de la présente invention.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Dans la présente demande de brevet, l'élément mémoire est indifféremment appelé « le filament » ou « le filament métallique ». Le dispositif mémoire résistive est également appelé « point mémoire ».

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé » se réfèrent à des positions prises selon la direction z.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z.

Un élément situé « à l'aplomb » ou « au droit» d'un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

On entend par « industriabilité » la mesure du caractère industrialisable.

Dans le cadre de la présente invention, on désigne par retrait horizontal ou retrait latéral un enlèvement de matière depuis une face sensiblement perpendiculaire au plan xy, selon une direction normale à cette face. Le retrait latéral d'une couche forme typiquement une marche ou un surplomb vis-à-vis des autres couches en-dessous ou au-dessus, respectivement. Le retrait latéral peut être formé sur une partie seulement du pourtour de l'élément mémoire. Le retrait latéral peut être formé sur tout le pourtour de l'élément mémoire. Dans ce dernier cas, selon une coupe transverse, on observe un retrait latéral de chaque côté de l'élément mémoire, soit deux retraits latéraux (qui sont en réalité deux parties du même retrait latéral).

Dans le cadre de la présente invention, le plan transverse est de préférence parallèle au plan horizontal xy. La section transverse de filament est mesurée dans le plan transverse. La plus petite dimension de la section transverse du filament est mesurée selon dans une direction dite transverse de ce plan transverse.

Les sections transverses d'électrode sont mesurées dans des plans parallèles au plan transverse. Les sections transverses d'électrode sont typiquement mesurées, selon l'axe z, à l'interface entre le filament et l'électrode.

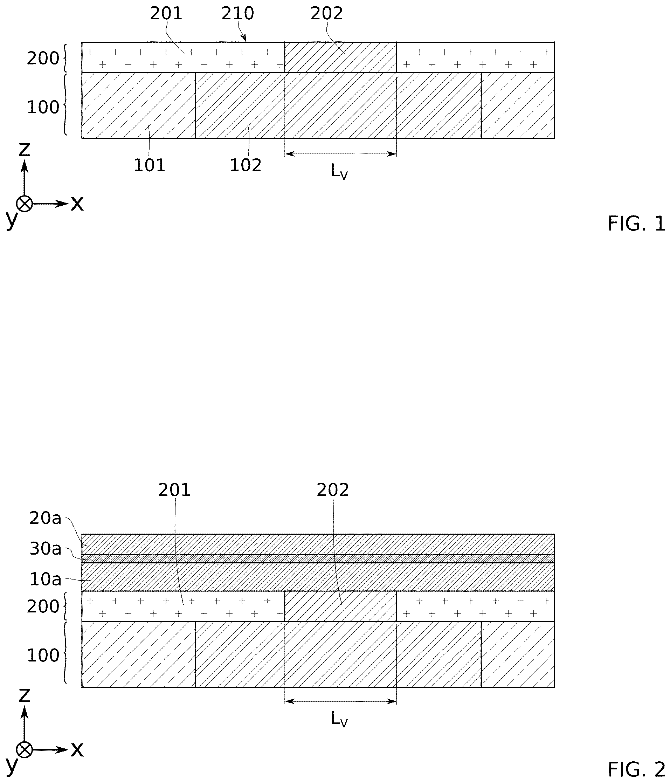

Les figures 1 à 8 illustrent un mode de réalisation du dispositif mémoire résistive et de son procédé de fabrication selon l'invention. Dans les exemples illustrés le dispositif mémoire résistive prend la forme d'un point mémoire de largeur L1. Ce point mémoire peut s'apparenter à un cylindre vertical comprenant les première et deuxième électrodes et le filament métallique. Il est typiquement formé à partir d'un empilement de couches, par des étapes de dépôts, lithographie, gravures. Ces différentes étapes sont détaillées dans la suite. D'autres formes de point mémoire ou de dispositif mémoire résistive sont parfaitement envisageables, par exemple un cube ou un parallélépipède, un cylindre de section carrée ou ellipsoïdale. La section peut être régulière ou irrégulière. Typiquement, une forme parfaite dessinée sur un masque de gravure est transférée dans l'empilement avec des imperfections liées aux technologies de lithographie et de gravure. Selon un principe de l'invention, un élément mémoire sous forme de filament à base d'un matériau métallique, est inséré dans l'empilement du point mémoire, entre les électrodes, et forme une constriction géométrique vis-à-vis des électrodes. Les matériaux d'électrode et le matériau métallique du filament sont de préférence choisis tels que, dans des conditions de gravure données, la vitesse de gravure du matériau métallique du filament est supérieure à la vitesse de gravure des matériaux d'électrode. Cela permet d'obtenir le filament par rétrécissement latéral du matériau métallique.

Le dispositif mémoire résistive est typiquement formé lors des étapes technologiques de fin de ligne, dites BEOL. Ainsi, comme illustré à la figure 1, un substrat (non illustré) portant différents niveaux de métal et de via est fourni. Sur la figure 1 d'illustration, seuls les derniers niveaux de métal et de via sont représentés. Le niveau métal 100 comprend typiquement des lignes ou pistes métalliques 102 isolées les unes des autres par un matériau diélectrique 101, typiquement du SiO2. Le niveau d'interconnexion 200 comprend typiquement des vias traversants 202 isolés les uns des autres par un matériau diélectrique 201, typiquement du SiN ou d'autres matériaux diélectriques tels que du SiC ou des matériaux dits « Ultra Low K ». Les vias 202 présentent typiquement une dimension en largeur Lv selon x. La largeur Lv des vias 202 est typiquement comprise entre quelques dizaines de nanomètres et quelques centaines de nanomètres, par exemple entre 5 et 1000 nanomètres, de préférence entre 10 et 500 nm. Une face 210 du dernier niveau 200 est exposée.

Comme illustré sur la figure 2, un empilement de couches 10a, 30a, 20a est formé sur la face exposée 210. Dans cet exemple une première couche 10a, destinée à former l'électrode inférieure, est déposée directement au contact de la face 210. Cette couche 10a est ici entièrement formée en un premier métal. Elle est de préférence à base d'un métal de transition, par exemple à base de Ti ou de TiN, ou encore de TaN. Zr, Hf, Ta, W peuvent également être utilisés.

Une fine couche 30a de métal est ensuite déposée par-dessus la première couche 10a. Cette couche 30a est ici entièrement formée en un troisième métal différent du premier métal. Cette couche 30a est de préférence à base d'un alliage d'aluminium et d'un métal de transition, par exemple à base de TixAly, avec x, y > 0, par exemple TiAl_{0,3}. Le pourcentage d'Aluminium de la couche 30a peut varier, par exemple entre 1% et 99%. Zr, Hf, Ta, W peuvent être utilisés en remplacement du Ti dans l'alliage d'aluminium de la couche 30a. La couche 30a est destinée à former l'élément mémoire.

Une deuxième couche 20a d'électrode, destinée à former l'électrode supérieure, est ensuite formée sur la couche de métal 30a. Cette deuxième couche 20a est ici entièrement formée en un deuxième métal différent du troisième métal. Elle est de préférence à base d'un métal de transition, par exemple à base de Ti ou de TiN, ou encore de TaN. Zr, Hf, Ta, W peuvent également être utilisés. La deuxième électrode 20 est de préférence à base du même métal que la première couche 10a.

Les couches 10a, 30a, 20a de métal sont de préférence directement au contact les unes des autres, comme illustré sur la figure 2. L'épaisseur de la première couche 10a est de préférence comprise entre 5 nm et 200 nm. L'épaisseur de la couche 30a est de préférence comprise entre 5 nm et 100 nm. L'épaisseur de la deuxième couche 20a est de préférence comprise entre 5 nm et 200 nm.

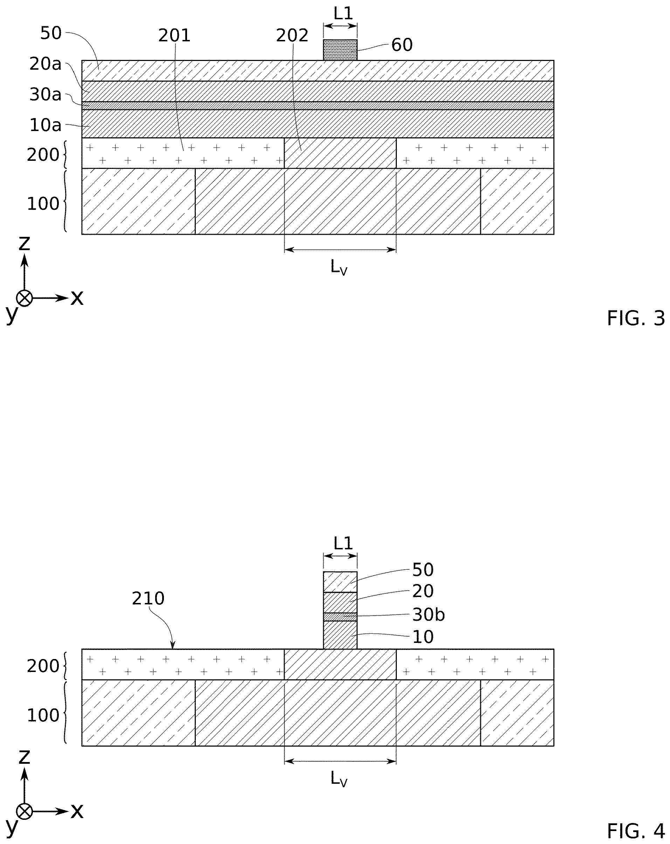

La figure 3 illustre une étape de lithographie effectuée préalablement à la gravure de l'empilement des couches d'électrodes et d'élément mémoire métallique. Un motif en résine 60 est formé à l'aplomb du via 202, par exemple de façon à ce que ledit motif 60 soit centré vis-à-vis du via 202, en projection dans le plan xy. Ce motif 60 définit la forme et les dimensions, en projection dans le plan xy, du point mémoire souhaité. Il présente typiquement au moins une dimension en largeur L1 supérieure ou égale à 50nm de préférence supérieure ou égale à 100 nm. Une couche de masque dur 50, par exemple à base de SiN ou de SiO2, peut être déposée sur l'électrode supérieure 20 avant formation du motif 60. De façon connue une telle couche 50 optionnelle permet de transférer plus fidèlement la forme et les dimensions du motif 60 dans l'empilement de couches 20, 30, 10 sous-jacentes, lors de la gravure suivante. Cette couche 50 permet également de protéger l'empilement lors de certaines étapes, notamment lors de l'étape d'enlèvement de la résine, couramment désignée par « stripping » selon le vocable anglais.

La figure 4 illustre la gravure de l'empilement des couches 20a, 30a, 10a, respectivement. Dans cet exemple, le masque dur 50 de largeur L1 est représenté. Classiquement, la couche 50 est d'abord gravée de façon anisotrope selon z. Le motif 60 en résine est alors retiré. Puis l'ensemble de l'empilement des couches 20a, 30a, 10a est gravé de façon anisotrope selon z.

Cette dernière gravure se fait de préférence par plasma en chimie chlorée. Cela permet d'obtenir un empilement de largeur L1, comprenant, depuis la face 210, une première électrode 10 par exemple à base de TiN, une couche métallique 30b par exemple à base de TixAly, une deuxième électrode 20 par exemple à base de TiN. L'arrêt de la gravure se fait de préférence sur le via 202 exposé, au niveau de la face 210. Cet arrêt de gravure n'est pas forcément sélectif, notamment parce que le ou les vias 202 peuvent être en TiN.

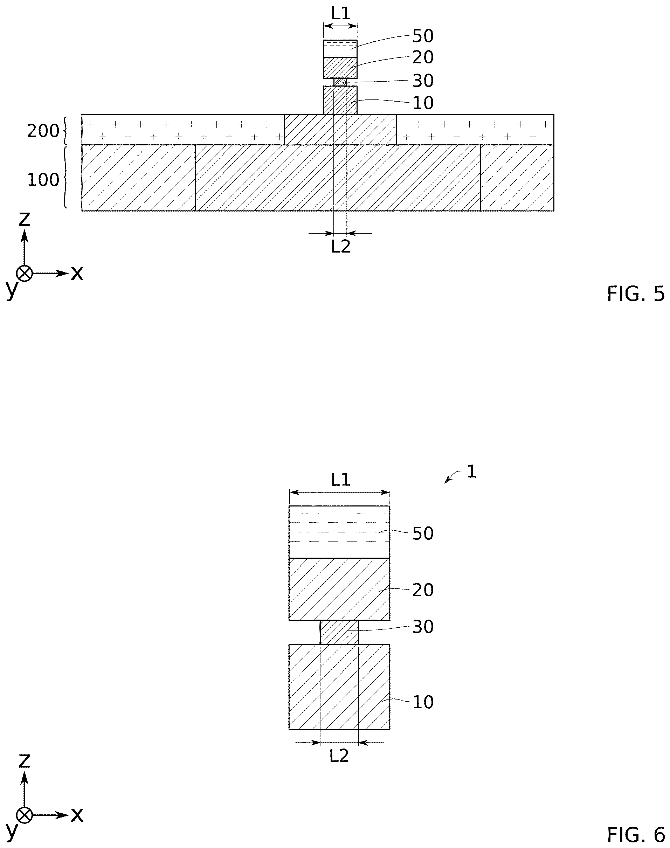

La figure 5 illustre une étape de surgravure permettant de réduire en largeur la couche métallique 30b uniquement, en conservant sensiblement la dimension L1 pour les autres couches 10, 20 de l'empilement. Lors de la surgravure, la couche 30b à base de TixAly se grave latéralement, selon x en coupe sur la figure 5, jusqu'à obtenir un « filament » 30 métallique de dimension L2. La surgravure se fait typiquement de part et d'autre des flancs de l'empilement, de sorte que le filament métallique 30 reste environ centré vis-à-vis des première et deuxième électrodes 10, 20. Un retrait latéral est ainsi obtenu de chaque côté du filament 30. Ce retrait peut ainsi être symétrique vis-à-vis de l'axe z passant par le centre de l'empilement. Selon une autre possibilité, le retrait latéral peut être formé de façon asymétrique, la surgravure pouvant être influencée par la densité de motifs de part et d'autre du point mémoire.

La surgravure est configurée de manière à ce que la dimension L2 du filament 30 soit inférieure ou égale à 20 nm, et de préférence inférieure ou égale à 15 nm, par exemple de l'ordre de 10 nm selon x et/ou selon y. La durée de la surgravure peut en particulier être ajustée en fonction du retrait latéral souhaité. Selon un exemple, les paramètres de la surgravure sont sensiblement les mêmes que ceux de la gravure. La surgravure correspond alors à une augmentation de la durée de gravure. Selon une autre possibilité, les paramètres de la surgravure sont modifiés, typiquement de façon à ce que l'isotropie de la surgravure soit augmentée. Selon un exemple, la tension de bias appliquée au plasma est diminuée voire annulée. Cela augmente le caractère isotrope du plasma. Selon un exemple, la pression et/ou les débits volumiques des gaz du plasma sont augmentés. Cela augmente le caractère isotrope du plasma.

La figure 6 illustre schématiquement le point mémoire 1 obtenu à l'issue de la surgravure. Le filament métallique 30 est intercalé entre les électrodes 10, 20, avec un facteur d'aspect L1/L2 ≥ 5.

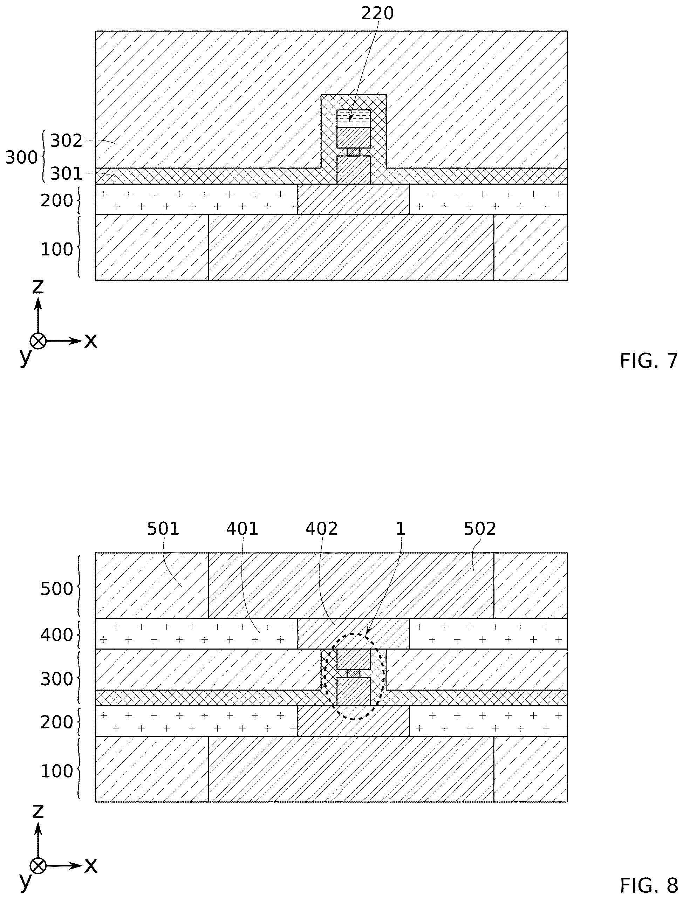

Comme illustré à la figure 7, le point mémoire est ensuite encapsulé par une ou plusieurs couches diélectriques, par exemple par une première couche 301 de SiN, puis par une deuxième couche 302 de SiO2. La première couche 301 de SiN présente par exemple une épaisseur de 30 nm. Elle est déposée de façon conforme sur le point mémoire. La couche 302 de SiO2 peut présenter une épaisseur de 300 nm. Ces couches 301, 302 forment un niveau d'encapsulation diélectrique 300 autour du point mémoire. Selon une possibilité alternative, ce niveau d'encapsulation diélectrique 300 peut être formé par une seule couche, par exemple par une couche à base de SiO2 ou de SiN.

Après dépôt de la ou des couches diélectriques 301, 302, une étape de planarisation, par exemple par polissage mécano chimique, est effectuée de manière à exposer une face supérieure 220 de l'électrode supérieure 20.

Comme illustré à la figure 8, des niveaux de via 400 et de métal 500 sont ensuite formés après l'étape de planarisation. Cela permet de former un contact métallique sur le point mémoire 1. Le niveau d'interconnexion 400 comprend typiquement des vias traversants 402 isolés les uns des autres par un matériau diélectrique 401, typiquement du SiN. Le ou les vias 402 sont de préférence centrés vis-à-vis de l'électrode supérieure 20 du point mémoire 1. Sur la figure 8, les vias des niveaux 200, 400 sont représentés plus larges que la dimension L1 du point mémoire 1. Selon une autre possibilité, les vias d'un ou des niveaux 200, 400 peuvent présenter une dimension selon x et/ou selon y inférieure à la dimension L1 du point mémoire 1. Le niveau métal 500 comprend typiquement des lignes métalliques 502 isolées les unes des autres par un matériau diélectrique 501, typiquement du SiO2.

Le dispositif 1 illustré à la figure 8 est ainsi parfaitement fonctionnel. Le contact haut formé par le via 402 et la ligne métallique 502, et le contact bas formé par le via 202 et la ligne métallique 102, peuvent être formés de façon classique, sans contraintes dimensionnelles particulières. Le dispositif 1 peut ainsi être réalisé par des étapes technologiques standard de la micro-électronique. L'introduction d'une couche métallique entre les électrodes du point mémoire, en empilement, couplée à la réalisation d'une surgravure sélective de cette couche métallique intercalée, permet de former avantageusement le filament métallique du point mémoire.

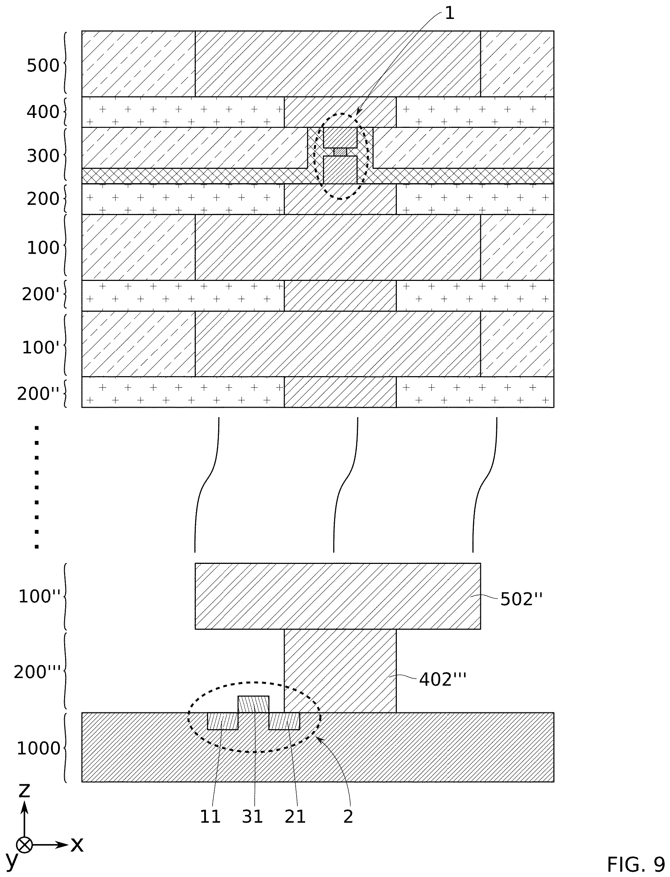

La figure 9 illustre un mode de réalisation préféré du dispositif et de son procédé de fabrication.

Dans cet exemple, le dispositif mémoire résistive 1 est relié à un transistor de commande 2 via un ou plusieurs niveaux de métal 100, 100', 100" et/ou d'interconnexions 200, 200', 200", 200"'. Le transistor de commande 2 peut être un transistor à effet de champ comprenant une grille 31 et des source et drain 11, 21. La connexion entre le dispositif mémoire 1 et le transistor 2 se fait typiquement en série, par exemple par l'intermédiaire d'un via 402"' connecté au drain 21 du transistor 2, et d'un premier niveau de métal 502". Le transistor de commande 2 est configuré pour contrôler un passage du courant dans le filament métallique du dispositif 1.

Le dispositif mémoire résistive 1 est avantageusement intégré dans l'empilement des niveaux BEOL et connecté au transistor 2 du niveau FEOL. Une telle intégration permet de limiter la tension nécessaire à la commutation du dispositif mémoire résistive 1. La commande du dispositif est optimisée. La fiabilité du dispositif mémoire résistive 1 est améliorée. Le système comprenant le dispositif mémoire résistive 1 et le transistor 2 reliés par au moins un niveau d'interconnexions et/ou de métal est directement réalisable dans un circuit intégré. L'intégration du système est améliorée.

Dans cet exemple, le dispositif mémoire résistive 1 est formé entre des niveaux d'interconnexions 200, 400. D'autres niveaux de métal 500 et/ou d'interconnexions peuvent typiquement surmonter le dispositif 1.

De nombreuses configurations d'empilement incluant un dispositif mémoire résistive 1 et un transistor 2 sont possibles. Ces variantes ne sont pas nécessairement illustrées mais peuvent être facilement déduites par combinaison des caractéristiques des modes de réalisation décrits.

L'invention n'est pas limitée aux modes de réalisation précédemment décrits mais uniquement par la portée des revendications suivantes.

## Revendications

1. Dispositif mémoire résistive (1) comprenant au moins une première électrode (10) à base d'un premier métal et une deuxième électrode (20) à base d'un deuxième métal, et un élément mémoire (30) sous forme de filament métallique à base d'un troisième métal et intercalé entre lesdites première et deuxième électrodes (10, 20), ledit élément mémoire (30) présentant une section transverse de filament, prise dans un plan dit transverse passant entre les première et deuxième électrodes (10, 20), et lesdites première et deuxième électrodes (10, 20) présentant chacune une section transverse d'électrode, prise respectivement dans un plan passant par ladite électrode (10, 20) et parallèle au plan transverse, tel que la section transverse de filament soit strictement inférieure aux sections transverses d'électrodes et tel que la section transverse de filament présente au moins une dimension L2 inférieure ou égale à 20 nm, le dispositif étant **caractérisé en ce que** le troisième métal présente une composition chimique différente de celles des premier et deuxième métaux et lui conférant une vitesse de gravure supérieure à celles des premier et deuxième métaux, de préférence telle que la sélectivité à la gravure soit supérieure ou égale à 2:1, et de préférence supérieure ou égale à 3:1, vis-à-vis des premier et deuxième métaux.

2. Dispositif (1) selon la revendication précédente dans lequel les première et deuxième électrodes (10, 20) et l'élément mémoire (30) sont empilés selon une direction dite verticale (z), sur un substrat (1000) s'étendant selon un plan (xy) dit horizontal et perpendiculaire à la direction verticale (z).

3. Dispositif (1) selon la revendication précédente dans lequel l'élément mémoire (30) forme un retrait latéral vis-à-vis des première et deuxième électrodes (10, 20) dans toutes les directions du plan horizontal (xy), de sorte que ledit élément mémoire (30) soit sensiblement centré vis-à-vis des première et deuxième électrodes (10, 20), en projection dans le plan horizontal (xy).

4. Dispositif (1) selon l'une quelconque des revendications précédentes, dans lequel les premier et deuxième métaux sont à base d'un métal de transition ou d'un nitrure dudit métal de transition, et le troisième métal est à base d'un alliage d'aluminium et dudit métal de transition, ou d'un autre métal de transition.

5. Dispositif (1) selon l'une quelconque des revendications précédentes, dans lequel la section transverse de filament présente une dimension L2 inférieure ou égale à 15 nm dans le plan transverse, et dans lequel les sections transverses d'électrodes présentent chacune une dimension L1 supérieure ou égale à 100 nm, dans un plan parallèle audit plan transverse.

6. Dispositif (1) selon l'une quelconque des revendications précédentes dans lequel les premier et deuxième métaux sont à base de Ti ou de TiN, et le troisième métal est à base de TixAly, avec x, y > 0.

7. Système comprenant un dispositif (1) selon l'une quelconque des revendications précédentes et un transistor (2) formé dans un substrat (1000) portant ledit dispositif (1), le transistor (2) étant relié au dispositif (1) par au moins un niveau d'interconnexions (200, 200', 200", 200"'), le transistor (2) étant en outre configuré pour commander un passage de courant électrique dans l'élément mémoire (30), entre les première et deuxième électrodes (10, 20).

8. Procédé de réalisation d'un dispositif mémoire résistive (1) selon l'une quelconque des revendications 1 à 6, comprenant :
• un dépôt d'une première couche (10a) à base du premier métal, sur un substrat (1000),
• un dépôt d'une troisième couche (30a) à base du troisième métal, sur la première couche (10),
• un dépôt d'une deuxième couche (20a) à base du deuxième métal, sur la troisième couche (30a), de sorte à former un empilement des première, troisième et deuxième couches (10a, 30a, 20a), selon une direction verticale (z),
• une gravure de l'empilement, selon la direction verticale (z), de façon à former les première et deuxième électrodes (10, 20),
• une surgravure configurée pour consommer latéralement, selon une direction horizontale d'un plan (xy) horizontal perpendiculaire à la direction verticale (z), le troisième métal sélectivement aux premier et deuxième métaux, de façon à former l'élément mémoire (30) sous forme de filament métallique intercalé entre lesdites première et deuxième électrodes (10, 20).

9. Procédé selon la revendication précédente dans lequel la surgravure est réalisée par plasma à base d'une chimie chlorée.

10. Procédé selon l'une quelconque des deux revendications précédentes dans lequel la surgravure correspond à une prolongation de l'étape de gravure, par application d'un temps de gravure supérieur à celui permettant de graver l'empilement selon la direction verticale (z).

11. Procédé selon l'une quelconque des revendications 8 à 9 dans lequel la gravure est configurée pour être anisotrope selon la direction verticale (z), et la surgravure est configurée pour être isotrope, de sorte que l'élément mémoire (30) forme un retrait latéral vis-à-vis des première et deuxième électrodes (10, 20) dans toutes les directions du plan horizontal (xy), ledit élément mémoire (30) étant ainsi sensiblement centré vis-à-vis des première et deuxième électrodes (10, 20), en projection dans le plan horizontal (xy).

12. Procédé selon l'une quelconque des revendications 8 à 11 dans lequel les premier et deuxième métaux sont choisis à base de Hf, Zr, W, Ti, Ta, TaN ou TiN, et le troisième métal est choisi à base de TixAly, ZrxAly, HfxAly, TaxAly, WxAly avec x, y > 0.

13. Procédé selon l'une quelconque des revendications 8 à 12 configuré pour réaliser un système selon la revendication 7, ledit procédé comprenant en outre une intégration de l'empilement sur un substrat (1000) comprenant un transistor (2) configuré pour commander un passage de courant électrique dans l'élément mémoire (30), entre les première et deuxième électrodes (10, 20), ladite intégration comprenant au moins la formation de connexions électriques (102, 202, 402"', 502") entre ledit transistor (2) et l'une au moins parmi les première et deuxième électrodes (10, 20).

## Patentansprüche

1. Resistive Speichervorrichtung (1), die mindestens eine erste Elektrode (10) basierend auf einem ersten Metall, und eine zweite Elektrode (20) basierend auf einem zweiten Metall umfasst, und ein Speicherelement (30) in Form eines metallischen Fadens basierend auf einem dritten Metall und zwischen die erste und die zweite Elektrode (10, 20) eingefügt, wobei das Speicherelement (30) einen Fadenquerschnitt aufweist, der in einer als Querebene bezeichneten Ebene, die zwischen der ersten und der zweiten Elektrode (10, 20) durchgeht, genommen ist, und wobei die erste und zweite Elektrode (10, 20) jeweils einen Elektrodenquerschnitt aufweisen, der jeweils in einer Ebene genommen ist, die durch die Elektrode (10, 20) durchgeht und derart parallel zu der Querebene, dass der Fadenquerschnitt strikt kleiner ist als die Querschnitte von Elektroden, und derart, dass der Fadenquerschnitt mindestens eine Abmessung L2 kleiner oder gleich 20 nm aufweist, wobei die Vorrichtung **dadurch gekennzeichnet ist, dass** das dritte Metall eine chemische Zusammensetzung aufweist, die sich von der des ersten und des zweiten Metalls unterscheidet und ihr eine Ätzgeschwindigkeit größer als diejenigen des ersten und des zweiten Metalls verleiht, bevorzugt derart, dass die Ätzselektivität in Bezug auf das erste und das zweite Metall größer oder gleich 2:1 und bevorzugt größer oder gleich 3:1 ist.

2. Vorrichtung (1) nach dem vorstehenden Anspruch, wobei die erste und die zweite Elektrode (10, 20) und das Speicherelement (30) entlang einer als vertikal bezeichneten Richtung (z) auf einem Substrat (1000) gestapelt sind, das sich entlang einer als horizontal bezeichneten Ebene (xy) und senkrecht zu der vertikalen Richtung (z) erstreckt.

3. Vorrichtung (1) nach dem vorstehenden Anspruch, wobei das Speicherelement (30) einen seitlichen Rücksprung in Bezug auf die erste und die zweite Elektrode (10, 20) in alle Richtungen der horizontalen Ebene (xy) derart bildet, dass das Speicherelement (30) im Wesentlichen in Bezug auf die erste und die zweite zweiten Elektrode (10) in der horizontalen Ebene (xy) vorragend zentriert ist.

4. Vorrichtung (1) nach einem der vorstehenden Ansprüche, wobei das erste und das zweite Metall auf einem Übergangsmetall oder einem Nitrid des Übergangsmetalls basieren, und das dritte Metall auf einer Aluminiumlegierung des Übergangsmetalls oder einem anderen Übergangsmetall basiert.

5. Vorrichtung (1) nach einem der vorstehenden Ansprüche, wobei der Fadenquerschnitt eine Abmessung L2 kleiner oder gleich 15 nm in der Querebene aufweist, und wobei die Querschnitte von Elektroden in einer Ebene parallel zu der Querebene jeweils eine Abmessung L1 größer oder gleich 100 nm aufweisen.

6. Vorrichtung (1) nach einem der vorstehenden Ansprüche, wobei das erste und das zweite Metall auf Ti oder TiN basieren, und das dritte Metall auf TixAly basiert, wobei x, y > 0.

7. System, das eine Vorrichtung (1) nach einem der vorstehenden Ansprüche und einen Transistor (2) umfasst, der in einem Substrat (1000) gebildet ist, das die Vorrichtung (1) trägt, wobei der Transistor (2) mit der Vorrichtung (1) durch mindestens eine Verbindungsebene (200, 200', 200'', 200‴) verbunden ist, wobei der Transistor (2) außerdem dazu konfiguriert ist, einen elektrischen Stromdurchgang in dem Speicherelement (30) zwischen der ersten und der zweiten Elektrode (10, 20) zu steuern.

8. Verfahren zur Herstellung einer resistiven Speichervorrichtung (1) nach einem der Ansprüche 1 bis 6, das Folgendes umfasst:
• eine Abscheidung einer ersten Schicht (10a) basierend auf dem ersten Metall, auf einem Substrat (1000),
• eine Abscheidung einer dritten Schicht (30a) basierend auf dem dritten Metall, auf der ersten Schicht (10),
• eine Abscheidung einer zweiten Schicht (20a) basierend auf dem zweiten Metall auf der dritten Schicht (30a) derart, dass eine Stapelung der ersten, dritten und zweiten Schicht (10a, 30a, 20a) entlang einer vertikalen Richtung (z) gebildet wird,
• eine Ätzung der Stapelungen entlang der vertikalen Richtung (z) derart, dass die erste und die zweite Elektrode (10, 20) gebildet werden,
• eine Überätzung, die dazu konfiguriert ist, seitlich entlang einer horizontalen Richtung einer horizontalen Ebene (xy) senkrecht zu der vertikalen Richtung (z) das dritte Metall selektiv gegenüber dem ersten und dem zweiten Metall derart zu verbrauchen, dass das Speicherelement (30) in Metallfadenform zwischen der ersten und der zweiten Elektrode (10, 20) eingefügt gebildet wird.

9. Verfahren nach dem vorstehenden Anspruch, wobei die Überätzung durch Plasma auf chlorhaltiger Chemie basierend durchgeführt wird.

10. Verfahren nach einem der beiden vorstehenden Ansprüche, wobei die Überätzung einer Verlängerung des Ätzschritts durch Anwenden einer längeren Ätzzeit als der entspricht, die das Ätzen der Stapelung entlang der vertikalen Richtung (z) erlaubt.

11. Verfahren nach einem der Ansprüche 8 bis 9, wobei die Ätzung dazu konfiguriert ist, entlang der vertikalen Richtung (z) anisotrop zu sein, und die Überätzung dazu konfiguriert ist, isotrop zu sein, so dass das Speicherelement (30) einen seitlichen Rücksprung in Bezug auf die erste und die zweite Elektrode (10, 20) in allen Richtungen der horizontalen Ebene (xy) bildet, wobei das Speicherelement (30) damit im Wesentlichen in Bezug auf die erste und die zweite Elektrode (10, 20) in der horizontalen Ebene (xy) vorragend im Wesentlichen zentriert ist.

12. Verfahren nach einem der Ansprüche 8 bis 11, wobei das erste und das zweite Metall basierend auf Hf, Zr, W, Ti, Ta, Ta N oder TiN ausgewählt werden, und das dritte Metall basierend auf TixAly, ZrxAly, HfxAly, TaxAly, WxAly ausgewählt wird, wobei x, y > 0.

13. Verfahren nach einem der Ansprüche 8 bis 12, das dazu konfiguriert ist, ein System nach Anspruch 7 durchzuführen, wobei das Verfahren außerdem eine Integration der Stapelung auf einem Substrat (1000) umfasst, das einen Transistor (2) umfasst, der dazu konfiguriert ist, einen Durchgang elektrischen Stroms in dem Speicherelement (30) zwischen der ersten und der zweiten Elektrode (10, 20) zu steuern, wobei die Integration mindestens das Bilden elektrischer Anschlüsse (102, 202, 402‴, 502'') zwischen dem Transistor (2) und mindestens einer der ersten und zweiten Elektrode (10, 20) umfasst.

## Claims

1. Resistive memory device (1) comprising at least one first electrode (10) based on a first metal and a second electrode (20) based on a second metal, and a memory element (30) in the form of a metal filament based on a third metal and inserted between said first and second electrodes (10, 20), said memory element (30) having a filament cross-section, taken in a so-called transverse plane passing between the first and second electrodes (10, 20), and said first and second electrodes (10, 20) each have an electrode cross-section, taken respectively in a plane passing through said electrode (10, 20) and parallel to the transverse plane, such that the filament cross-section is strictly smaller than the electrode cross-sections and such that the filament cross-section has at least one dimension L2 less than or equal to 20nm, the device being **characterised in that** the third metal has a chemical composition different from those of the first and second metals giving it an etching speed greater than those of the first and second metals, preferably such that the selectivity at the etching is greater than or equal to 2:1, and preferably greater than or equal to 3:1, vis-à-vis the first and second metals.

2. Device (1) according to the preceding claim, wherein the first and second electrodes (10, 20) and the memory element (30) are stacked in a so-called vertical direction (z), on a substrate (1000) extending in a so-called horizontal plane (xy) and perpendicular to the vertical direction (z).

3. Device (1) according to the preceding claim, wherein the memory element (30) forms a lateral removal vis-à-vis the first and second electrodes (10, 20) in all the directions of the horizontal plane (xy), such that said memory element (30) is substantially centred vis-à-vis the first and second electrodes (10, 20), projecting in the horizontal plane (xy).

4. Device (1) according to any one of the preceding claims, wherein the first and second metals are based on a transition metal or a nitride of said transition metal, and the third metal is based on an alloy of aluminum and of said transition metal, or on another transition metal.

5. Device (1) according to any one of the preceding claims, wherein the filament cross-section has a dimension L2 less than or equal to 15nm in the transverse plane, and wherein the electrode cross-sections each have a dimension L1 greater than or equal to 100nm, in a plane parallel to said transverse plane.

6. Device (1) according to any one of the preceding claims, wherein the first and second metals are based on Ti or TiN, and the third metal is based on TixAly, with x, y > 0.

7. System comprising a device (1) according to any one of the preceding claims and a transistor (2) formed in a substrate (1000) carrying said device (1), the transistor (2) being connected to the device (1) by at least one interconnecting level (200, 200', 200", 200‴), the transistor (2) further being configured to control an electric current passage in the memory element (30), between the first and second electrodes (10, 20).

8. Method for producing a resistive memory device (1) according to any one of claims 1 to 6, comprising:
• a deposition of a first layer (10a) based on the first metal, on a substrate (1000),
• a deposition of a third layer (30a) based on the third metal, on the first layer (10),
• a deposition of a second layer (20a) based on the second metal, on the third layer (30a), so as to form a stack of the first, third and second layers (10a, 30a, 20a), in a vertical direction (z),
• an etching of the stack, in the vertical direction (z), so as to form the first and second electrodes (10, 20),
• an over-etching configured to laterally consume, in a horizontal direction of a horizontal plane (xy) perpendicular to the vertical direction (z), the third metal selectively over the first and second metals, so as to form the memory element (30) in the form of a metal filament inserted between said first and second electrodes (10, 20).

9. Method according to the preceding claim, wherein the over-etching is done by plasma based on a chlorinated chemistry.

10. Method according to any one of the two preceding claims, wherein the over-etching corresponds to an extension of the etching step, by application of an etching time greater than that making it possible to etch the stack in the vertical direction (z).

11. Method according to any one of claims 8 to 9, wherein the etching is configured to be anisotropic in the vertical direction (z), and the over-etching is configured to be isotropic, such that the memory element (30) forms a lateral removal vis-à-vis the first and second electrodes (10, 20) in all the directions of the horizontal plane (xy), said memory element (30) thus being substantially centred vis-à-vis the first and second electrodes (10, 20), projecting in the horizontal plane (xy).

12. Method according to any one of claims 8 to 11, wherein the first and second metals are chosen based on Hf, Zr, W, Ti, Ta, TaN or TiN, and the third metal is chosen based on TixAly, ZrxAly, HfxAly, TaxAly, WxAly with x, y > 0.

13. Method according to any one of claims 8 to 12, configured to produce a system according to claim 7, said method further comprising an integration of the stack on a substrate (1000) comprising a transistor (2) configured to control an electric current passage in the memory element (30), between the first and second electrodes (10, 20), said integration comprising at least the formation of electric connections (102, 202, 402"', 502") between said transistor (2) and at least one from among the first and second electrodes (10, 20).
